# EUROPÄISCHE PATENTSCHRIFT

(11) **EP 0 840 897 B1**
(45) Veröffentlichungstag und Bekanntmachung des Hinweises auf die Patenterteilung: **16.05.2001**
(21) Anmeldenummer: 96927515.5
(22) Anmeldetag: 17.07.1996
(51) Int. Cl.: G01R 31/327

(54) **VERFAHREN ZUR FUNKTIONSPRÜFUNG EINES MECHANISCHEN SCHALTELEMENTES**
FUNCTIONAL TEST PROCESS FOR A MECHANICAL SWITCHING ELEMENT
PROCEDE POUR CONTROLER LE FONCTIONNEMENT D'UN ELEMENT DE COMMUTATION MECANIQUE

(30) Priorität: 26.07.1995 DE 19529013
(43) Veröffentlichungstag der Anmeldung: 13.05.1998
(73) Patentinhaber: SIEMENS AKTIENGESELLSCHAFT, 80333 München (DE)
(72) Erfinder: BALTZER, Martin, D-10623 Berlin (DE); SCHUCKAR, Detlev, D-12355 Berlin (DE); GONZALEZ, Rocco, D-10765 Berlin (DE)
(86) Internationale Anmeldenummer: DE9601379
(87) Internationale Veröffentlichungsnummer: WO9705500

(56) Entgegenhaltungen:
- DE-A- 3 419 752
- US-A- 5 270 900

## Beschreibung

Die Erfindung betrifft ein Verfahren zur Funktionsprüfung eines, insbesondere als Auslöser in einem Hochspannungs-Leistungsschalter ausgebildeten mechanischen Schaltelementes mit einer zeitweise stromdurchflossenen Spule und einem beweglichen Spulenkern, bei welchem Verfahren durch die magnetische Wirkung eines eine Spule durchfließenden Stromes eine Bewegung eines Spulenkernes in Gang gesetzt wird, wobei die Spule mit einem elektrischen Impuls beaufschlagt wird, und der Verlauf des Stromes durch die Spule mittels einer Überwachungseinrichtung gemessen und differenziert wird.

Bei einem bekannten Verfahren zur Funktionsprüfung eines mechanischen Schaltelementes einer elektrischen Schaltanlage (Elektrizitätswirtschaft, Jg. 94 (1995), Heft 7) erfolgt ein Funktionstest im Ruhezustand, d. h. ein Meßimpuls, der in festgelegten zeitlichen Abständen auf einen Lastkreis aufgebracht wird, ist so kurz, daß eine Bewegung des Schaltelementes nicht ausgelöst wird. Hierdurch wird nur die Leitfähigkeit des Lastkreises überprüft. Es ist dort keine Kontrolle der mechanischen Bewegbarkeit des Schaltelementes möglich.

Aus der US-PS 5,270,900 ist bekannt, daß ein elektromagnetisches Schaltelement, das von einer Spule mit einem Kern gebildet ist, zum Öffnen und Schließen eines Ventiles benutzt wird. Die Bewegung des Kernes, die zum Öffnen des Ventiles führt, wird mittels eines elektrischen Impulses, der auf die Spule aufgebracht wird ausgelöst. Die Öffnungsdauer des Ventils wird durch einen Zähler vorgegeben. Um den Zeitpunkt für den Start des Zählers zu bestimmen, wird der Stromverlauf in der Spule gemessen und differenziert. Nachdem die Ableitung des gemessenen Stromes einen vorher festgelegten Wert erreicht hat, wird der Zähler gestartet. Nach Ablauf des Zählers wird das Ventil mittels des Schaltelementes wieder geschlossen.

Der Erfindung liegt die Aufgabe zugrunde, ein Verfahren der eingangs beschriebenen Art zur Funktionsprüfung eines mechanischen Schaltelementes zu schaffen, bei welchem die mechanische Funktionsfähigkeit des Schaltelementes überprüft wird, ohne einen Schaltvorgang des Schaltelementes vollständig auszuführen.

Diese Aufgabe wird erfindungsgemäß dadurch gelöst, daß der elektrische Impuls abgeschaltet wird, sobald die Ableitung des gemessenen Stromverlaufes einen bestimmten Wert erreicht.

Der wesentliche Vorteil, der mit der Erfindung erreicht wird, besteht in einer flexiblen Kontrollmöglichkeit des Schaltelementes mittels einer begrenzten Bewegung des Kernes der Spule. Durch die Bewegung des Kernes in der Spule ändert sich deren Induktivität und der magnetische Fluß. Somit wird der zeitliche Verlauf des Stromes in der Spule von der Bewegung beeinflußt.

Durch die Überwachung der zeitlichen Ableitung des Stromverlaufes in der Spule ist das Abschalten des elektrischen Impulses, der auf die Spule aufgebracht wird, direkt von der Bewegung des Kernes abhängig.

Der für das Abschalten des elektrischen Impulses herangezogene und durch Differenzierung des Stromverlaufes durch die Spule ermittelte Zeitpunkt ist lediglich von der tatsächlich erfolgten Bewegung des Kernes abhängig. Somit bewirkt eine leichtere Beweglichkeit des Kernes bei besonderen Betriebsbedingungen (z. B. erhöhte Temperatur) eine entsprechend frühere Abschaltung des elektrischen Impulses. Daher ist die tatsächlich zurückgelegte Wegstrecke des Kernes bis zum Abschalten des elektrischen Impulses weitgehend unabhängig von den äußeren Betriebsbedingungen. Dies ist wichtig, um zu gewährleisten, daß das erfindungsgemäße Verfahren unter unterschiedlichen Bedingungen einsetzbar ist, ohne daß ein Risiko besteht, im Zuge des Prüfverfahrens irrtümlich einen Schaltvorgang im Hochspannungs-Leistungsschalter auszulösen.

Vorteilhaft kann vorgesehen sein, daß die Impulshöhe bei der Funktionsprüfung geringer ist als bei einem tatsächlichen Auslösevorgang.

Dies kann beispielsweise dadurch erreicht werden, daß der Spule bei der Funktionsprüfung ein Vorwiderstand vorgeschaltet wird.

Bei einer weiteren vorteilhaften Ausgestaltung der Erfindung kann vorgesehen sein, daß der elektrische Impuls abgeschaltet wird, sobald die Ableitung des gemessenen Stromverlaufes erstmals nach Beginn des elektrischen Impulses das Vorzeichen wechselt.

Der Zeitpunkt des Vorzeichenwechsels der Ableitung des gemessenen Stromverlaufes ist ein besonders gut durch Messung zu ermittelnder Punkt. Er eignet sich deshalb in besonderer Weise als ein Auslösezeitpunkt für das Abschalten des elektrischen Impulses.

Vorteilhaft kann auch vorgesehen sein, daß als Quelle für den elektrischen Impuls eine Konstantspannungsquelle benutzt wird.

Eine Konstantspannungsquelle ist ein leicht verfügbares Gerät zur Erzeugung elektrischer Spannungsimpulse.

Es kann auch vorteilhaft sein, daß nach dem Abschalten des elektrischen Impulses eine pulsweitenmodulierte Folge von weiteren Impulsen in der Spule erzeugt wird, deren zeitlicher Strommittelwert eine kontrollierte Bewegung des Spulenkernes bewirkt.

Hierdurch läßt sich der Stößel kontrolliert bis zur Verriegelungseinrichtung bewegen, ohne eine Entriegelung zu bewirken. Darauf kann der Leerhub des Auslösers gemessen werden.

Als vorteilhafte Ausgestaltung der Einrichtung zur Durchführung des Verfahrens zur Funktionsprüfung kann vorgesehen sein, daß die Einrichtung einen Impulsgeber zur Einspeisung eines elektrischen Impulses, eine Überwachungseinrichtung zur Messung und Differenzierung des Stromverlaufes in der Spule, einen nachgeschalteten Komparator, eine Einrichtung zur Einstellung des Schwellwertes des Komparators und eine Steuereinrichtung zum Abschalten des elektrischen Impulses, sobald die Ableitung des gemessenen Stromverlaufes einen bestimmten Wert erreicht hat, aufweist.

Hierdurch ist ein einfach zu erstellender Aufbau der Kontrolleinrichtung gegeben, der an die jeweils gegebenen Bedingungen bei der Funktionsprüfung verschiedener Varianten elektromagnetischer Auslöser nicht individuell angepaßt zu werden braucht.

Im folgenden wird eine Ausführungsform der Erfindung im Zusammenhang mit einer Zeichnung genauer beschrieben.

Es zeigen:
- Figur 1: ein schematisches Blockschaltbild zu dem erfindungsgemäßen Verfahren zur Funktionsprüfung eines mechanischen Schaltelementes,
- Figur 2A: einen schematischen Kurvenverlauf des Stromes in der Spule und dessen zeitlicher Ableitung,
- Figur 2B: einen Kurvenverlauf des von dem Kern zurückgelegten Weges,
- Figur 3A: einen zeitlichen Verlauf der in die Spule eingespeisten elektrischen Impulse,
- Figur 3B: einen schematischen Kurvenverlauf des Stromes in der Spule,
- Figur 3C: einen schematischen Kurvenverlauf des vom Kern zurückgelegten Weges,
- Figur 3D: einen schematischen Kurvenverlauf der magnetischen Kraft,
- Figur 4: ein schematisches Blockschaltbild zum Verfahren für die Messung des Auslösehubes.

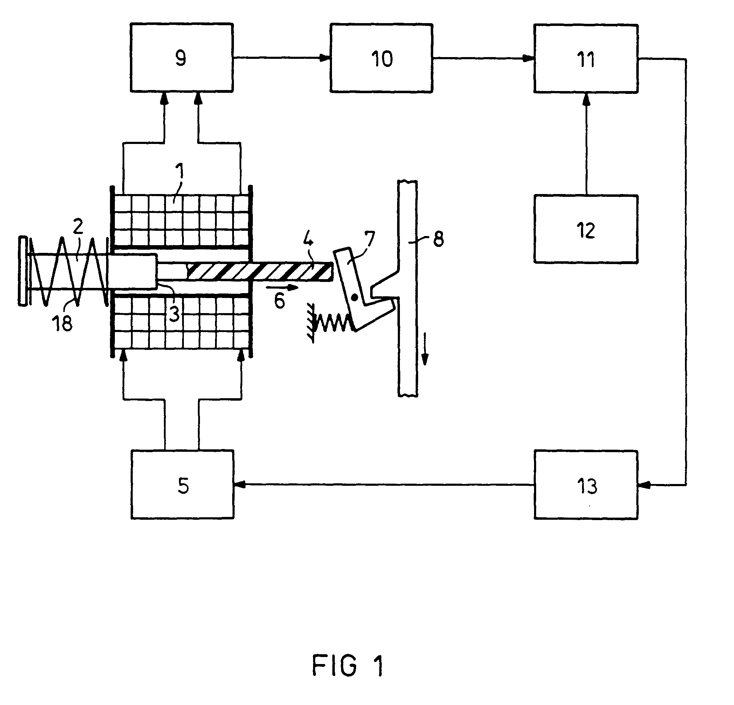

Gemäß Figur 1 ist in einem nicht dargestellten Hochspannungs-Leistungsschalter ein elektromagnetischer Auslöser gebildet durch einen in einer Spule 1 angeordneten ferromagnetischen Kern 2, an dessen einer Stirnseite 3 ein Stößel 4 aus einem unmagnetischen Material angebracht ist. Wird auf die Spule 1 mittels eines Impulsgebers 5 ein elektrischer Impuls aufgebracht, so bewegen sich der Kern 2 und der Stößel 4 in Richtung des Pfeiles 6. Bei der Funktionsprüfung soll der von dem Kern 2 und dem Stößel 4 zurückgelegte Weg begrenzt werden, um ein Entriegeln der Elemente 7, 8 des Hochspannungs-Leistungsschalters zu verhindern. Um dies zu erreichen, wird mittels einer Strommeßeinrichtung 9 der in der Spule während der Beaufschlagung mit dem elektrischen Impuls fließende Strom gemessen. Mittels eines Differenziergliedes 10 wird die zeitliche Ableitung des gemessenen Stromverlaufes ermittelt. Der Verlauf der zeitlichen Ableitung des Stromes bildet die erste Eingangsgröße eines Komparators 11. Der Komparator 11 wird mittels einer Einstelleinrichtung 12 mit einem Schwellwert an seinem Referenzeingang beaufschlagt. Erreicht die in den Komparator 11 eingespeiste erste Größe den Schwellwert, so gibt der Komparator ein Signal an eine Steuereinheit 13, die ihrerseits ein Signal an den Impulsgeber 5 abgibt, um das Abschalten des elektrischen Impulses zu bewirken.

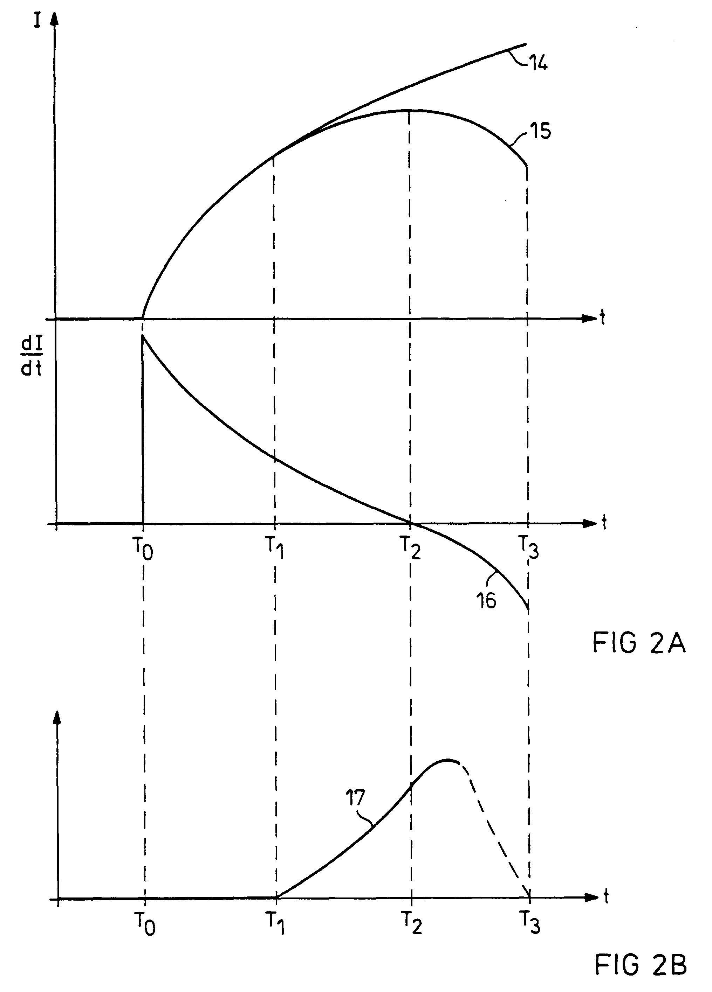

Wird eine reale Spule zu einem Zeitpunkt T₀ mit einem elektrischen Impuls beaufschlagt, so zeigt der Stromverlauf in der Spule 1 den in Figur 2A schematisch dargestellten zeitlichen Verlauf 14. Ist in der Spule 1 ein beweglicher Kern 2 angeordnet, so wird durch die durch den elektrischen Impuls zum Zeitpunkt T₁ ausgelöste Bewegung des Kernes 2 der zeitliche Verlauf des Stromes in der Spule beginnend von dem Zeitpunkt T₁ an gegenüber dem Verlauf ohne Bewegung des Kernes verändert. Der veränderte zeitliche Verlauf des Stromes ist durch eine Kurve 15 schematisch in Figur 2A dargestellt.

Zum Zeitpunkt T₂ durchläuft die Kurve 15 im Unterschied zu der Kurve 14 ohne eine Bewegung des Kernes ein lokales Maximum. Der Anstieg der Kurve 15 ist zu diesem Zeitpunkt Null. Die Ableitung 16 der Kurve 15 hat zum Zeitpunkt T₂ einen Nulldurchgang. T₂ ist deshalb ein besonders gut durch Messung ermittelbarer Punkt des Kurvenverlaufes 16. Er wird deshalb vorteilhaft benutzt, um den Zeitpunkt für das Abschalten des elektrischen Impulses, der auf die Spule aufgebracht wird, zu ermitteln. In der Figur 2B ist der von dem Kern 2 zurückgelegte Hub 17 gegen die Zeit aufgetragen. Nach Abschalten des Impulses bei T₂ bewegt sich der Kern 2 noch ein Stück weiter, um dann von einer Rückholfeder 18 zurückbewegt zu werden.

Mittels der Einstelleinrichtung 12 des Komparators 11 kann jedoch indirekt ein beliebiger Zeitpunkt zwischen T₁ und T₂ oder nach T₂ festgelegt werden, zu dem das Abschalten des elektrischen Impulses stattfinden soll. Der Abschaltzeitpunkt für den Impuls kann immer so gewählt werden, daß durch die Bewegung des Kernes 2 und des Stößels 4 in Richtung des Pfeiles 6 die Elemente 7, 8 des Hochspannungs-Leistungsschalters nicht entriegelt werden.

Die bisher beschriebene Erfindung kann vorteilhaft zur Messung des Hubes eines mechanischen Schaltelementes, insbesondere eines Auslösers in einem Hochspannungs-Leistungsschalter eingesetzt werden.

Der Auslöserhub setzt sich aus dem Leerhub H_{L} und dem Arbeitshub H_{W} zusammen. Wird die Auslöserspule 1 mit einem elektrischen Impuls beaufschlagt, so bewegen sich der Kern 2 und der Stößel 4, ohne mechanische Arbeit zu leisten, zunächst bis zu den Elementen 7, 8 des Hochspannungs-Leistungsschalters. Der hierbei zurückgelegte Weg wird als Leerhub H_{L} bezeichnet. Von diesen Punkt an muß der Kern mechanische Arbeit leisten um die Elemente 7, 8 zu entriegeln. Der zurückgelegte Weg, bis zur vollständigen Entriegelung, wird als Arbeitshub H_{W} bezeichnet.

Zur Messung des Leerhubes H_{L} ist eine Bewegung des Stößels 4 bis zur Berührung mit dem Element 7 notwendig. Dabei sollen die Elemente 7, 8 nicht entriegelt werden. Der Stößel 4 und der Kern 2 sollen in dieser Position verharren.

Zur Messung des Arbeitshubes H_{W} müssen der Stößel 4 und der Kern 2 die Elemente 7, 8 vollständig entriegeln und in der Entriegelungsposition verharren, d.h. der volle Auslöserhub muß zurückgelegt werden.

Gemäß der beschriebenen Erfindung wird der elektrische Impuls abgeschaltet sobald die Ableitung des gemessenen Stromverlaufes einen bestimmten Wert erreicht. Dadurch wird eine begrenzte Bewegung des Kernes 2 und des Stößels 4 gewährleistet. Aufgrund der mechanischen Gegenkraft der Rückholfeder 18 werden der Kern 2 und der Stößel 4 in die Ausgangsposition gebracht, sobald der elektrische Impuls abgeschaltet wird.

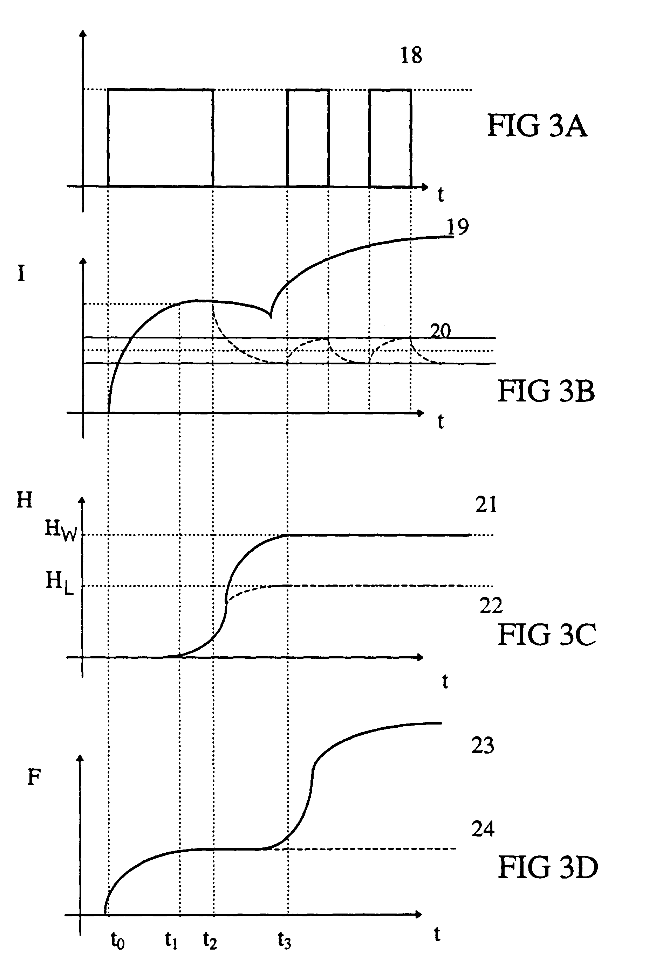

Wird, wie weiter oben beschrieben, der elektrische Impuls zum Zeitpunkt T₂, wie in Fig. 2A gezeigt, abgeschaltet (siehe Fig. 3B) so sinkt der Stromverlauf nach einer kurzen Bewegung (einem Zucken), des Kerns exponentiell. Durch das Einspeisen von weiteren elektrischen Impulsen von definierter Länge (siehe Fig. 3A) kann ein sägezahnförmiger Stromverlauf innerhalb eines Toleranzbereiches eingestellt werden, dessen Strommittelwert größer oder gleich dem benötigten Haltestromwert an dieser Position des Kerns ist. Schaltet man nämlich den elektrischen Impuls ab wenn der Stromverlauf einen bestimmten Wert überschreitet und wieder ein wenn der Stromverlauf einen bestimmten Wert unterschreitet so ergibt sich ein sägezahnförmiger Stromverlauf mit kleiner Amplitude. Diese Regelungsart wird Zweipunktregelung genannt. Als Führungsgröße dieser Regelung kann z.B. der Anzugsstrom gewählt werden, d.h. der Stromwert der eine Bewegung des Spulenkernes in Gang setzt. Dadurch wird ein Zurückfahren des Kerns verhindert (siehe Fig. 3C).

Zur Regelung des Strommittelwertes kann eine Stromregelung die nach dem PWM-(Pulsweitenmodulation) Prinzip arbeitet, eingesetzt werden, d.h. die Breite der elektrischen Impulse wird in Abhängigkeit von der Stromdifferenz zwischen dem Sollwert und dem Istwert des Stromes verändert. Ist die Stromdifferenz positiv, so wird ein elektrischer Impuls erzeugt, der den Stromverlauf im Auslöserzweig ansteigen läßt. Die Breite des elektrischen Impulses in der Spule ist proportional zur Stromdifferenz. Ist die Stromdifferenz negativ oder gleich null, so wird kein elektrischer Impuls erzeugt.

Als Führungsgröße dieser Regelung kann wieder der Anzugsstrom dienen.

Die Stromregelung greift sofort nach dem Funktionstest des Auslösers ein. Ist der Funktionstest positiv, d.h. bewegt sich der Kern, so wird die Auslöserhubmessung durchgeführt, sonst wird die Auslöserhubmessung nicht durchgeführt.

Aufgrund des breiteren Luftspaltes in der Ausgangsposition des Kerns ist der benötigte Anzugsstrom in dieser Stellung wesentlich höher als der benötigte Haltestrom in jeder anderen Stellung des Kerns. Wird der Anzugsstrom als Führungsgröße für die Stromregelung genutzt so wird sich der Kern langsam weiter vorwärts bewegen.

Um den Stößel 4 bis hin zur Berührung mit dem Element 7 zu bewegen, muß der eingestellte Stromwert, d.h. die Führungsgröße des Regelkreises so hoch gewählt werden, daß vermieden wird, daß die Feder 18 den Kern 2 zurückbewegt. Der Stromverlauf darf nicht unter den Stromwert absinken der gerade notwendig ist, um den Kern in dieser Position zu halten.

Ziel dieses Verfahrens ist es, den Stößel 4 bis zur Berührung mit dem Element 7 zu bewegen und dabei die Elemente 7, 8 nicht zu entriegeln. Während der Stößel in dieser Position gehalten wird kann der Leerhub als Differenz zwischen der Ausgangsposition und dieser Position mit einem Längenmeßgerät gemessen werden. Um das zu erreichen, muß die Kraft, die der Auslöser entwickelt, kleiner sein als die Gegenkraft der Elemente 7, 8.

Der Anzugsstrom erzeugt in der Ausgangsposition des Kerns gerade die notwendige Kraft, um die Gegenkraft der Rückholfeder zu kompensieren und den Kern langsam vorwärts zu bewegen. An einer anderen Position des Kerns erzeugt dieselbe Anzugsstromstärke jedoch eine höhere Kraft. Ist die Gegenkraft, die von den Elementen 7, 8 aufgebracht wird, größer als die vom Auslöser erzeugte Kraft in der Position, in der der Stößel und das Element 7 einander berühren, so verharren der Kern und der Stößel in dieser Position. Ist die Gegenkraft, die von den Elementen 7, 8 aufgebracht wird, niedriger als die vom Auslöser erzeugte Kraft so werden die Elemente 7, 8 entriegelt und es muß ein neuer Meßvorgang gestartet werden. Das kann verhindert werden, indem als Führungsgröße des Stromreglers ein geringerer Stromwert gewählt wird. Ein geringerer Stromwert bedeutet, daß eine geringere Kraft durch den Auslöser erzeugt wird, jedoch darf diese Kraft nicht geringer werden als die zum Halten des Kerns benötigte Kraft.

Die Kraft, die der Auslöser an einer bestimmten Position des Kernes 2 entwickelt, ist proportional zum Quadrat des Stromes F~i² |_{x=const} . Somit läßt sich die Kraft relativ einfach über den Strom einstellen, wenn die Position des Kernes bekannt ist. Nach dem Anzugsvorgang vergrößert sich die magnetische Kraft aufgrund der Zunahme des magnetischen Flusses und der Abnahme des Luftspaltes (siehe Fig. 3D, Kurve 23) bei annähernd gleichem Stromwert. Wird nun der Stromwert geringer, so sinkt auch die magnetische Kraft.

Es kann auch vorgesehen sein, daß eine Diode und ein ohmscher Widerstand zueinander in Reihe und zur Auslöserspule parallel geschaltet werden, um den exponentiellen Abfall des Stromes einzustellen.

Die magnetische Energie, die in der Spule gespeichert wird, wird jeweils beim Abschalten des elektrischen Impulses in elektrische Energie umgewandelt. Diese elektrische Energie wird in Form von Wärme abgegeben. Werden ein ohmscher Widerstand und eine für den Abschaltvorgang in Durchlaßrichtung geschaltete Diode parallel zur Auslöserspule geschaltet, so wird die elektrische Energie über dem Widerstand in Wärme umgewandelt. Durch Verändern des Widerstandswertes kann nun die Zeitkonstante des exponentiellen Stromabfalls eingestellt werden. Hierdurch kann die Zeit eingestellt werden, die bis zum Erreichen der Führungsgröße bzw. des vorgegebenen Stromwertes in der Regelung benötigt wird.

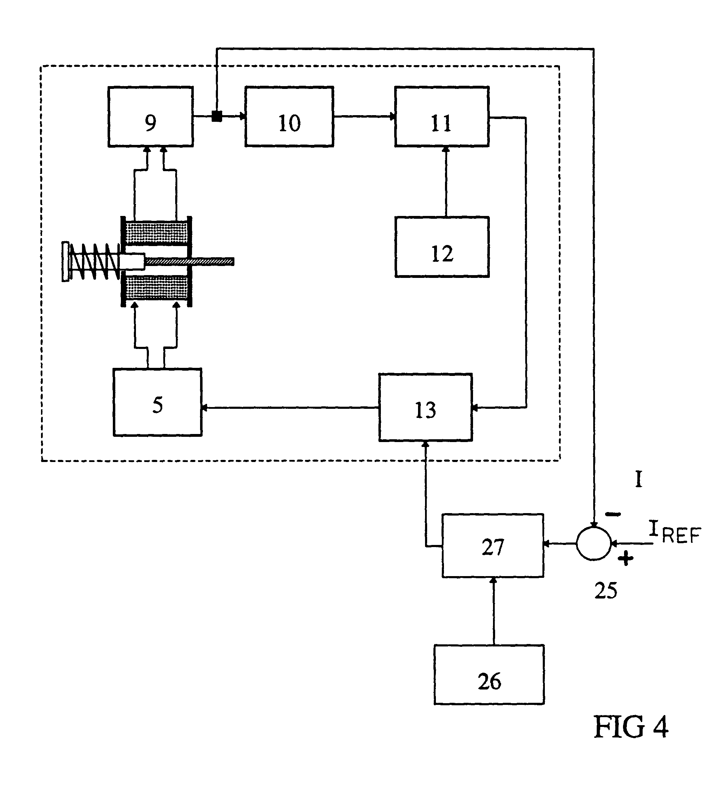

Es kann auch vorgesehen sein, daß ein Stromregler einsetzt wird, der aus einer Vergleichseinrichtung 25, einem Frequenzgenerator 26 und einer Modulationseinrichtung 27 besteht, (siehe Fig. 4). Mit der Vergleichseinrichtung 25 wird die Differenz zwischen dem eingestelltem Stromsollwert und dem momentanen Stromwert bestimmt. Diese Differenz ist die erste Eingangsgröße für die Modulationseinrichtung 27. Die zweite Eingangsgröße sind die Rechteckimpulse, die durch den Frequenzgenerator 26 erzeugt werden. Aufgrund der Stromdifferenz wird die Breite der Rechteckimpulse verändert (moduliert). Diese modulierten Impulse werden als zweite Eingangsgröße auf die Steuereinheit 13 gegeben, die ihrerseits ein Signal an den Impulsgeber 5 abgibt.

Es erfolgt eine Pulsweitenmodulation (PWM), d.h. die Breite der elektrischen Impulse wird in Abhängigkeit von der Stromdifferenz zwischen dem Sollwert und dem Istwert des Stromes verändert.

Ist der Leerhub gemessen worden, so kann der Strom durch die Spule soweit vergrößert werden, daß die Elemente 7, 8 entriegelt werden und der Stößel den Arbeitshub durchläuft. Es kann die Position vor der Entriegelung und nach der Entriegelung gemessen werden. Die Differenz dieser beiden Positionen stellt den Arbeitshub dar.

## Patentansprüche

1. Verfahren zur Funktionsprüfung eines, insbesondere als Auslöser in einem Hochspannungs-Leistungsschalter ausgebildeten mechanischen Schaltelementes mit einer zeitweise stromdurchflossenen Spule (1) und einem beweglichen Spulenkern (2), bei welchem Verfahren durch die magnetische Wirkung eines die Spule (1) mit dem Spulenkern (2) durchfließenden Stromes eine Bewegung des Spulenkernes (2) in Gang gesetzt wird, wobei die Spule (1) mit einer Spannung zur Erzeugung eines elektrischen Impulses beaufschlagt wird, und der Verlauf des Stromes durch die Spule (1) mittels einer Überwachungseinrichtung gemessen und differenziert wird,
**dadurch gekennzeichnet**, daß
die Spannung abgeschaltet wird, sobald die Ableitung des gemessenen Stromverlaufes einen bestimmten Wert erreicht.

2. Verfahren nach Anspruch 1,
**dadurch gekennzeichnet**, daß
die Impulshöhe bei der Funktionsprüfung geringer ist als bei einem tatsächlichen Auslösevorgang.

3. Verfahren zur Funktionsprüfung nach Anspruch 1 oder 2,
**dadurch gekennzeichnet**, daß
die Spannung abgeschaltet wird, sobald die Ableitung des gemessenen Stromverlaufes erstmals nach Beginn des elektrischen Impulses das Vorzeichen wechselt.

4. Verfahren zur Funktionsprüfung nach einem der vorhergehenden Ansprüche,
**dadurch gekennzeichnet**, daß
als Quelle für die Spannung eine Konstantspannungsquelle dient.

5. Verfahren nach einem der vorhergehenden Ansprüche,
**dadurch gekennzeichnet**, daß
nach dem Abschalten der Spannung eine pulsweitenmodulierte Folge von weiteren Impulsen in der Spule erzeugt wird, durch deren zeitlichen Strommittelwert die Bewegung des Spulenkernes steuerbar ist.

6. Einrichtung zur Durchführung des Verfahrens zur Funktionsprüfung nach Anspruch 1 oder einem der folgenden, mit einem Impulsgeber (5) zur Einspeisung einer Spannung zur Erzeugung eines elektrischen Impulses, einer Überwachungseinrichtung zur Messung (9) und Differenzierung (10) des Stromverlaufes in der Spule (1), einem nachgeschalteten Komparator (11), einer Einrichtung (12) zur Einstellung des Schwellwertes des Komparators (11) und einer Steuereinrichtung (13) zum Abschalten der Spannung,
**dadurch gekennzeichnet**, **daß**
die Steuereinrichtung derart beschaffen ist, daß sie die Spannung abschaltet, sobald die Ableitung des gemessenen Stromverlaufes einen bestimmten Wert erreicht, und daß die Steuereinrichtung zusätzlich eine Modulationseinrichtung (27) zur pulsweitenmodulierten Ansteuerung der Spule (1) aufweist.

## Claims

1. Functional test process for a mechanical switching element designed in particular as a trip element in a high-voltage circuit-breaker and having an, at times, energized coil (1) and a movable coil core (2), in which process the magnetic effect of a current flowing through the coil (1) having the coil core (2) initiates a movement of the coil core (2), wherein a voltage is applied to the coil (1) to generate an electrical pulse, and the flow of current through the coil (1) is measured and differentiated by means of a monitoring device,
**characterized in that**
the voltage is disconnected as soon as the derivative of the measured current flow reaches a specific value.

2. Process according to claim 1,
**characterized in that**
the pulse height during functional testing is lower than during an actual tripping operation.

3. Functional test process according to claim 1 or 2,
**characterized in that**
the voltage is disconnected as soon as the derivative of the measured current flow changes sign for the first time after the start of the electrical pulse.

4. Functional test process according to one of the preceding claims,
**characterized in that**
a constant-voltage source is used as a source for the voltage.

5. Process according to one of the preceding claims,
**characterized in that,**
after the voltage is disconnected, there is generated in the coil a pulse-duration-modulated train of further pulses, the time current average of which is used to control the movement of the coil core.

6. Device for effecting the functional test process according to claim 1 or one of the following claims, comprising a pulse generator (5) for supplying a voltage to generate an electrical pulse, a monitoring device for measuring (9) and differentiating (10) the current flow in the coil (1), a downstream comparator (11), a device (12) for setting the threshold value of the comparator (11), and a control device (13) for disconnecting the voltage,
**characterized in that**
the control device is such that it disconnects the voltage as soon as the derivative of the measured current flow reaches a specific value, and that the control device additionally comprises a modulation device (27) for pulse-duration-modulated control of the coil (1).

## Revendications

1. Procédé de vérification du fonctionnement d'un élément de commutation mécanique, réalisé notamment en déclencheur dans un disjoncteur à haute tension, comportant une bobine (1) dans laquelle du courant passe par intermittence un noyau (2) de bobine mobile, l'effet magnétique d'un courant passant dans la bobine (1) avec le noyau (2) de bobine mettant en marche, dans ce procédé, un déplacement du noyau (2) de bobine, la bobine (1) étant alimentée en une tension pour produire une impulsion électrique, et la courbe du courant dans la bobine (1) étant mesurée et dérivée au moyen d'un dispositif de surveillance, caractérisé en ce que la tension est interrompue dès que la dérivée de la courbe du courant mesurée atteint une valeur déterminée.

2. Procédé suivant la revendication 1, caractérisé en ce que l'amplitude d'impulsion est plus petite lors de la vérification du fonctionnement que lors d'une opération réelle de déclenchement.

3. Procédé de vérification du fonctionnement suivant la revendication 1 ou 2, caractérisé en ce que la tension est interrompue dès que la dérivée de la courbe du courant mesurée change pour la première fois de signe après le début de l'impulsion électrique.

4. Procédé de vérification du fonctionnement suivant l'une des revendications précédentes, caractérisé en ce que l'on utilise comme source pour la tension une source de tension constante.

5. Procédé suivant l'une des revendications précédentes, caractérisé en ce que, après l'interruption de la tension, il est produit dans la bobine une séquence d'impulsions supplémentaires modulées en largeur, par la valeur moyenne de courant dans le temps de laquelle le déplacement du noyau de la bobine peut être commandé.

6. Dispositif de mise en oeuvre du procédé de vérification de fonctionnement suivant la revendication 1 ou l'une des suivantes, comportant un générateur (5) d'impulsion pour injecter une tension en vue de produire une impulsion électrique, un dispositif de surveillance pour mesurer (9) et dériver (10) la courbe du courant dans la bobine (1), un comparateur (11) en aval, un dispositif (12) pour régler la valeur seuil du comparateur (11) et un dispositif (13) de commande pour interrompre la tension, caractérisé en ce que le dispositif de commande est réalisé de telle manière qu'il interrompt la tension dès que la dérivée de la courbe du courant mesurée atteint une valeur déterminée, et en ce que le dispositif de commande comporte de plus un dispositif (27) de modulation pour la commande avec modulation en largeur des impulsions de la bobine (1).
